Europäisches Patentamt

**European Patent Office**

**Office européen des brevets**

(11) Publication number: **0 047 655**
A1

# EUROPEAN PATENT APPLICATION

(21) Application number: **81304074.8**

(22) Date of filing: **07.09.81**

(51) Int. Cl.³: **H 01 L 23/42,** H 01 L 23/36,
H 05 K 7/20

(30) Priority: **08.09.80 JP 123580/80**

(43) Date of publication of application: **17.03.82**
**Bulletin 82/11**

(84) Designated Contracting States: **AT BE CH DE FR GB IT**
**LI LU NL SE**

(71) Applicant: **Hitachi, Ltd., 5-1, Marunouchi 1-chome,**
**Chiyoda-ku Tokyo 100 (JP)**

(72) Inventor: **Okada, Sadayuki, 821-7, Ichige, Katsuta-shi**
**(JP)**
Inventor: **Sonobe, Hisao, 2570-18 Tsuda Nakamachi,**
**Naka-gun Ibaraki-ken (JP)**

(74) Representative: **Paget, Hugh Charles Edward et al,**
**MEWBURN ELLIS & CO. 2/3 Cursitor Street, London**
**EC4A 1BQ (GB)**

(54) **Boiling/cooling system.**

(57)  A boiling/cooling system for cooling a semiconductor element in use thereof has at least one cooling member (5) including an evaporating section (5a) containing a liquid refrigerant of high vaporizability sealed in it and a condensing section (5d) for cooling the liquid refrigerant from the evaporating section when it is heated and vaporized. The semiconductor element is clamped to the evaporating section. To avoid problems arising from the application of a high voltage to the cooling member, a highly thermally conductive insulating material (4) is interposed between the semiconductor element (1) and the evaporating section (5a) and clamped into position by a metal clamp (10). The evaporating and condensing sections can thus be in a unitary structure.

BOILING/COOLING SYSTEM

1   BACKGROUND OF THE INVENTION

This invention relates to a boiling/cooling system for effecting cooling of semiconductor elements by utilizing the boiling and condensing of a liquid refrigerant which is highly vaporizable, such as Freon (dichlorodifluoromethane).

FIELD OF THE INVENTION

A boiling/cooling system generally comprises an evaporator having a refrigerant sealed therein, and a condenser located above the evaporator. Semiconductor elements are maintained in direct contact with the evaporator when they are cooled, so that the cooling device including the condenser has a high voltage impressed thereon. Thus electric dielectric breakdown or shortcircuiting would occur in portions of the condenser which are adjacent each other.

DESCRIPTION OF THE PRIOR ART

To obviate the aforesaid problem with which the system of the prior art has been faced with, a proposal has been made to connect the evaporator and the condenser together through a tube formed of aluminum oxide, porcelain or other insulating material.

In this type of boiling/cooling system, the internal pressure may vary from vacuum to 2-3 atmospheric pressures depending on the thermal load applied
to the semiconductor elements.  This makes it necessary
to use a hermetically sealed container for containing
the system.  In the prior art, the container includes
nonmetal-to-metal connections and connections formed
by dissimilar metals, so that highly developed bonding
techniques have been required to obtain a truly hermetic
container.  Additionally, the provision of the insulating
tube between the evaporator and the condenser requires
another metal material that bonds well with the insulating
material which would be interposed therebetween or a bellows which would be able to accommodate thermal expansion
and contraction.  The boiling/cooling system of the
prior art has thus had the following disadvantages.  The
condenser and the evaporator become large in size when
the aforesaid requirements are met.  Moreover, since
an insulating material is lower in strength than metal,
it is necessary to use a frame of high strength for
assembling the insulating tube with the evaporator and
the condenser, thereby making it impossible to obtain
a compact size in a boiling/cooling system.

SUMMARY OF THE INVENTION

This invention has as its object the provision
of a boiling/cooling system which can be formed of metal
in its entirety without requiring to interconnect the
evaporator and the condenser with an insulating material, so that the system is compact in size, highly hermetically sealed and highly reliable in performance.

The aforesaid object is accomplished according to the invention by providing an electric insulating material of high thermal conductivity interposed between the semiconductor elements and the cooling members (evaporator, condenser), to shut out the electrical influences exerted by the semiconductor elements and allow heat alone to pass to the evaporator in cooling the semiconductor elements.

BRIEF DESCRIPTION OF THE DRAWINGS

Fig. 1 is a fragmentary sectional view of the boiling/cooling system comprising a first embodiment of the invention;

Fig. 2 is a fragmentary sectional view of a second embodiment of the boiling/cooling system in conformity with the invention; and

Figs. 3 and 4 are a side view and a sectional view taken along the line IV-IV in Fig. 3, respectively, of a third embodiment of the boiling/cooling system in conformity with the invention.

DESCRIPTION OF THE PREFERRED EMBODIMENTS OF THE INVENTION

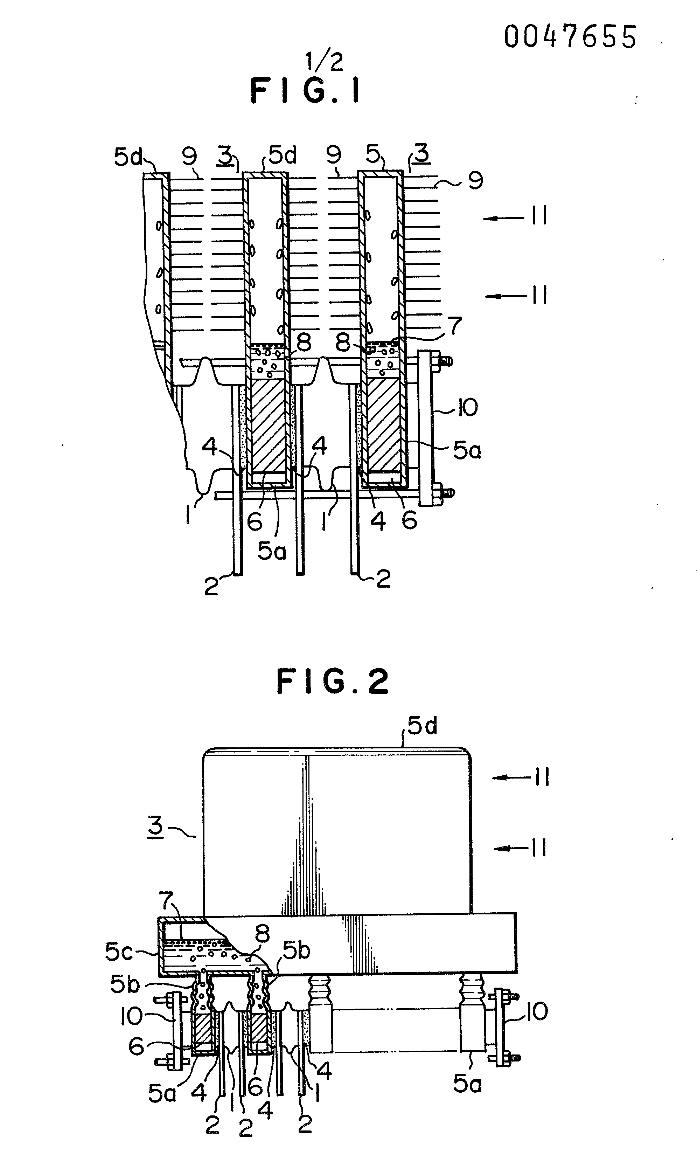

Referring to Fig. 1, the numeral 1 designates semiconductor elements which generates heat when a current is passed thereto, and the numeral 2 designates power source terminals disposed on opposite sides of each semiconductor element 1 in intimate contact therewith which are formed of copper of high electric and thermal conductivity. Cooling members 3 are each located adjacent one of the power source terminals 2, and a highly thermally conductive insulating material 4 is interposed between the cooling member 3 and the power source terminal 2. The highly thermally conductive insulating material 4 may be one of SiC ceramics and beryllia porcelain.

SiC ceramics comprise a sintered body formed of silicon carbide as its main constituent and added with at least one of beryllium oxide and boron nitride. The amount of beryllium oxide and boron nitride is optimally over 2 weight parts for 100 weight parts of silicon carbide.

Each cooling body 3 comprises an evaporating section 5a and a condensing section 5d which are hollow. The numeral 6 designates a boiling section formed of aluminum, copper, etc., of good thermal conductivity located within the evaporating section 5a. The boiling section 6 is immersed in a liquid refrigerant 7, such as Freon, which is highly vaporizable. The boiling section 6 has the additional function of avoiding the deformation of the evaporating section 5a when the latter is clamped by a clamping metal member 10 as subsequently to be described. The numeral 8 designates steam bubbles produced when the boiling section 6 undergoes overheating. The numeral 9 designates heat-dissipating fins attached to the outer wall surfaces of the condensing sections 5d which are cooled by cooling air currents indicated by arrows 11. The clamping metal member 10 referred to hereinabove clamps together the semiconductor elements 1, power source terminals 2, cooling members 3 and highly thermally conductive insulating material 4 when they are assembled in superposed relation into a unitary structure.

The boiling/cooling system of the first embodiment in conformity with the invention is of the aforesaid construction. When a current is passed from the power source terminals 2 to the semiconductor elements 1, the latter generate heat which is transmitted through the highly thermally conductive material 4 located on opposite sides of each semiconductor element 1 to the boiling section 6 in each evaporating section 5a by thermal transfer. The heated boiling section 6 causes the liquid refrigerant 7 to boil and produce the steam bubbles 8 which invade each condensing section 5d. In the condensing section 5d, the bubbles 8 are changed into a liquid state by the cool inner wall surface of the condensing section 5d that is cooled by the heat-dissipating fins 9, and the liquid refrigerant 7 returns to the evaporating section 5a where it cools the interior thereof again.

In this embodiment, by virtue of the highly thermally conductive insulating material 4 interposed between the semiconductor elements 1 and the cooling members 3, it is possible to eliminate the influence of a high voltage current in the vicinity of the semiconductor elements 1 that might otherwise be exerted on the cooling members 3. Thus the need to electrically insulate the evaporator against the condenser is eliminated, enabling the cooling members 3 to be formed of the same metal in its entirety. This offers many advantages. Fabrication of the system is facilitated, and it is possible to obtain a compact overall size in a boiling/cooling system because the lacks of insulating joints markedly reduces the height of the system. In addition, the evaporating section 5a and condensing section 5d can have their interior sealed with increased airtightness, thereby increasing the dependability of the system in performance.

Fig. 2 is a fragmentary sectional view in explanation of a second embodiment of the boiling/cooling system in conformity with the invention. Parts similar to those shown in Fig. 1 are designated by like reference characters. What distinguishes the second embodiment shown in Fig. 2 from the first embodiment shown in Fig. 1 is that whereas in Fig. 1 a plurality of cooling members 3 each comprising the evaporating section 5a and the condensing section 5d are provided for a plurality of semiconductor elements 1, in the embodiment shown in Fig. 2 a liquid sump section 5c is provided between the evaporating section 5a maintained in contact with the semiconductor elements 1 through the highly thermally conductive material 4 and the condensing section 5d disposed above the evaporating section 5a, and a flexible tube 5b is used to communicate the evaporating section 5a with the liquid sump section 5c. That is, the cooling member 3 comprises a plurality of evaporating sections 5a and one condensing section 5d. The function of the flexible tubes 5b is to accommodate displacements that might be caused to occur by thermal expansion and contraction between the liquid sump section 5c and the evaporating section 5a due to changes in the temperatures of the semiconductor elements 1, power source terminals 2, highly thermally conductive insulating material 4 and evaporating section 5a.

The second embodiment shown in Fig. 2 operates in the same manner as the first embodiment shown in Fig. 1. More specifically, as a current is passed to the semiconductor elements 1 from the power source terminals 2, the heat generated by the heated semiconductor elements 1 is transferred to opposite sides through the highly thermally conductive material 4 and then to the boiling section 6 in each evaporating section 5a. Overheating of the boiling section 6 causes the liquid refrigerant 7 in the evaporating section 5a to boil and produce the steam bubbles 8 which invade the liquid sump section 5c through the flexible tube 5b. From the liquid sump section 6, the bubbles 8 enter the condensing section 5d thereabove, where it is cooled by the currents of cooling air 11 and changes into a liquid state again, so that the liquid refrigerant 7 is returned to the evaporating sections 5a from the condensing section 5d via the liquid sump sections 5c, to cool the interior of each evaporating section 5a.

In the second embodiment of the aforesaid construction and operation, the provision of the highly thermally condudtive insulating material 4 is interposed between the semiconductor elements 1 and the cooling member 3, so that it is possible to form connections between each evaporating section 5a, each flexible tube 5b and each liquid sump section 5c all of metal. This eliminates the need to mount an insulating tube between the evaporator and the condenser or the liquid sump, so that the height of the system can be reduced and it is possible to obtain a compact size in a boiling/cooling system. Thus the system is easy to fabricate and highly reliable in performance because it can provide hermetic seal.

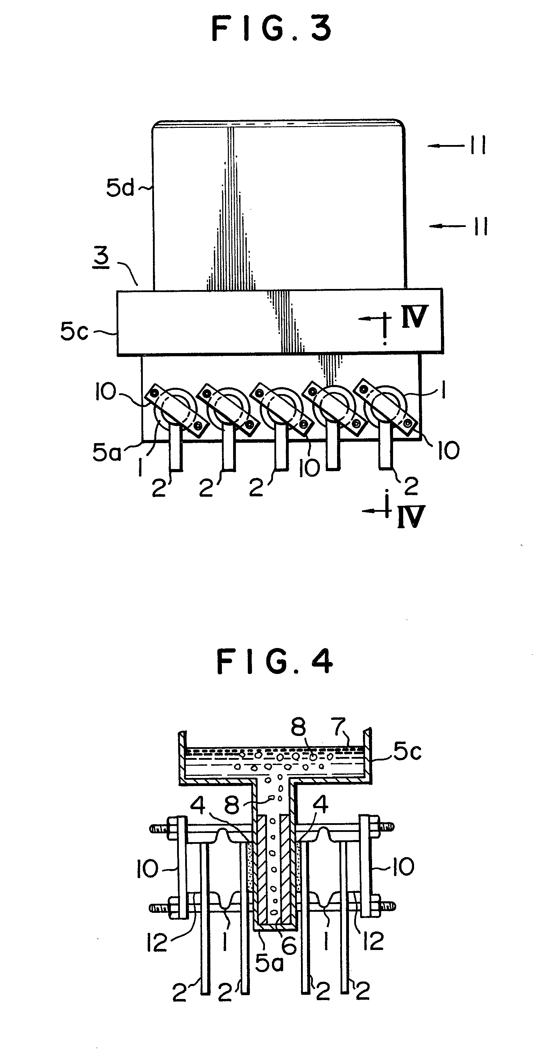

A third embodiment of the invention will be described by referring to Figs. 3 and 4. Parts similar to those shown in Fig. 1 and 2 (first and second embodiments) are designated by like reference characters in the figures. The distinctions between the third embodiment and the first and second embodiments are as follows. In the third embodiment, the cooling member 3 comprises the evaporating section 5a forming a lower portion, the condensing section 5d forming an upper portion and the liquid sump section 5c forming an intermediate portion.

The evaporating section 5a, condensing section 5d and liquid sump section 5c are formed into a unitary structure of hermetic construction, and a plurality of semiconductor elements 1 can be attached to opposite sides of the evaporating section 5a in the direction of flow of the currents of cooling air 11.

Further, 12 designates an electric insulating member. So as to mount the semiconductor 1 to the evaporating section 5a, the highly thermally conductive insulating material 4, the power source terminal 2, semiconductor 1, the power source terminal 2 and the electric insulating member 12 are piled up in turn, then they are clamped and secured by the outer clamping metal member 10.

Operation of the third embodiment is similar to that of the first and second embodiment, so that its explanation will be omitted.

In addition to achieving the effects achieved by the first and second embodiments, the third embodiment offers the advantage that the semiconductor elements can be readily replaced by new ones when they fail, because of their being attached to the opposite sides of the evaporating section 5a of large size in side-by-side relation.

In the third embodiment, the semiconductor elements have been shown and described as being attached to opposite sides of the evaporating section. However, it is to be understood that the invention is not limited

0047655

to this specific arrangement and that they may be attached to the end faces, bottom and other parts of the evaporating section by inserting a highly thermally conductive insulating material, depending on the shape and configuration of the evaporating section.

From the foregoing description, it will be appreciated that the cooling member or members are all electrically insulated, so that the system as a whole can be formed of metal. The boiling/cooling system provided by the invention is compact in size and highly reliable in performance because of its hermetic construction, so that it can provide a stable cooling function.

CLAIMS

1.       A boiling/cooling system comprising:

at least one cooling member (5) comprising an evaporating section (5a) having a liquid refrigerant (7) sealed therein, and a condensing section (5d) for cooling the liquid refrigerant from said evaporating section when it is vaporized by heating, to change it back to the liquid state; and

at least one semiconductor element (1) maintained in thermal contact with said evaporating section (5a) to be cooled thereby; characterized in that:

a highly thermally conductive insulating material (4) is interposed between said semiconductor element (1) and said evaporating section (5a).

2.       A boiling/cooling system as claimed in claim 1 wherein said insulating material (4) is an SiC ceramic or a beryllia porcelain.

3.       A boiling/cooling system as claimed in claim 2 wherein said insulating material (4) is a sintered body comprising silicon carbide as its main constituent and containing as additive at least one of beryllium oxide and boron nitride.

4.      A boiling/cooling system as claimed in claim 3, wherein said sintered body comprises over 2 weight parts of at least one of beryllium oxide and boron nitride per 100 parts by weight of said silicon carbide.

5.      A boiling/cooling system as claimed in any one of the preceding claims further comprising at least one power source terminal (2) interposed between said insulating material (4) and said semiconductor element (1).

6.      A boiling/cooling system as claimed in any one of the preceding claims further comprising a boiler (6) in said evaporating section, and wherein said evaporating section (5a) and said condensing section (5d) are formed into a unitary structure and heat-dissipating fins (9) are provided on the condensing section.

7.      A boiling/cooling system as claimed in any one of the preceding claims further comprising at least one liquid sump section (5c) interposed between said evaporating section (5a) and said condensing section (5d).

8.      A boiling/cooling system as claimed in claim 7 wherein said liquid sump section (5c) is common to a plurality of said evaporating sections extending downwardly from it, and wherein the or each semiconductor element (1) is located between two adjacent evaporation sections in thermal contact with both through the insulating material (1).

9. A boiling/cooling system as claimed in claim 7 wherein said evaporating section (5a) extends downwardly from said liquid sump section (5c) and a plurality of said semiconductor elements (1) are thermally in contact with opposite side walls of said evaporating section (5a) through the insulating material (4).

10. A boiling/cooling system as claimed in any one of the preceding claims further comprising a metal clamping member (10) for clamping said semiconductor element or elements, said evaporating section and said insulating material together into a unitary structure.

# FIG. 1

# FIG. 2

0047655

# FIG. 3

# FIG. 4

European Patent Office

**EUROPEAN SEARCH REPORT**

0047655

Application number

EP 81 30 4074.8

## DOCUMENTS CONSIDERED TO BE RELEVANT

| Category | Citation of document with indication, where appropriate, of relevant passages | Relevant to claim |
|---|---|---|
| | US - A - 4 020 399 (MITSUBISHI) <br> * claims 1, 2, 4, 5; column 3, line 51 to column 4, line 49; fig. 2, 3a * <br> -- | 1,6-10 |
| | DE - A1 - 2 825 582 (GENERAL ELECTRIC) <br> * claim 10; fig. 1 * <br> -- | 1,2,6, 7 |
| | Chemical Abstracts vol. 82, 1975 Columbus, Ohio, USA <br> S. TAKEHARA et al. "Sealant for an electrothermic wire" <br> page 236, column 2, abstract no. 174592c <br> & JP - B - 74 - 48 657 <br> -- | 3 |
| | WISSENSCHAFTLICHE BERICHTE AEG-TELEFUN-KEN, Vol. 51, No. 1, 1978, Berlin <br> P. HEINEMEYER et al. "Siedekühlung für Leistungshalbleiter" <br> * pages 30 to 39; fig. 5 b * <br> ---- | 1,7-10 |

**CLASSIFICATION OF THE APPLICATION (Int. Cl.³)**

H 01 L 23/42

H 01 L 23/36

H 05 K 7/20

**TECHNICAL FIELDS SEARCHED (Int. Cl.³)**

H 01 L 23/36

H 01 L 23/42

**CATEGORY OF CITED DOCUMENTS**

X: particularly relevant

A: technological background

O: non-written disclosure

P: intermediate document

T: theory or principle underlying the invention

E: conflicting application

D: document cited in the application

L: citation for other reasons

&: member of the same patent family, corresponding document

X The present search report has been drawn up for all claims

| Place of search <br> Berlin | Date of completion of the search <br> 30-11-1981 | Examiner <br> ROTHER |
|---|---|---|

EPO Form 1503.1 06.78